# EUROPEAN PATENT APPLICATION

(11) **EP 1 281 731 A1**
(43) Date of publication of application: **05.02.2003**
(21) Application number: 01930084.7
(22) Date of filing: 11.05.2001
(51) Int. Cl.: C09B 67/20, G03C 1/675, B41M 5/30

(54) **COLORING COMPOSITION**

(30) Priority: 11.05.2000 JP 2000139011
(71) Applicant: Toda Kogyo Corporation, Hiroshima-shi, Hiroshima-ken 730-0847 (JP); Ichimura, Kunihiro, Yokohama-shi, Kanagawa 226-0016 (JP)
(72) Inventor: ICHIMURA, Kunihiro, Midori-ku, Yokohama-shi, Kanagawa 226-00 (JP); ARIMITSU, Koji, Machida-shi, Tokyo 194-0011 (JP); TAHARA, Masaru, Tama-shi, Tokyo 206-0033 (JP); KURITA, Eiichi, Ono-cho, Saiki-gun, Hiroshima 739-0445 (JP)
(74) Representative: Waldren, Robin Michael
(86) International application number: JP0103959
(87) International publication number: WO01085851

(57) **Abstract**

A coloring composition added to a solid such as a solid resin is disclosed. The composition includes (i) a soluble coloring agent precursor obtained by substituting a hydrogen atom of a NH group of a pigment molecule having at least one NH group with an alkoxycarbonyl group of the following general formula (1): 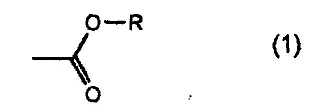 wherein R represents a tert-butyl group, a tert-amyl group, a 2-phenyl-2-propyl group or a diphenylmethyl group, (ii) an acid proliferation agent newly generating an acid by an action of an acid, and (iii) an acid former generating an acid by the action of activation energy rays or heat.

## Description

### TECHNICAL FIELD

This invention relates to a coloring composition having excellent transparency, to a transparent colored resin composition, to a composition for forming a transparent colored resin and to a transparent colored image.

### BACKGROUND ART

Typical methods for obtaining colored images include a method of transferring a coloring ink from a printing plate to a medium to be printed such as by letterpress printing, intaglio printing or planographic printing; a method of printing a coloring ink to a medium to be printed through a stencil such as by stencil printing; a method dying an image obtained by irradiating a light-sensitive polymer film with light; a method in which a previously colored photosensitive polymer film is irradiated with light and then subjected to a developing treatment; an electrostatic printing method in which a photoconductive film is exposed to light to form an electrostatic image, the image is subsequently developed with a coloring toner and transferred for fixation to a medium to be printed; and an ink jet method in which fine colored liquid droplets are injected to a medium to be printed. In these methods, except for the ink jet method, the formation of image is carried out by utilizing a change in physical properties of a photosensitive material occurring between exposed and non-exposed regions. A colored image is formed by depositing a coloring agent thereto.

The coloring agents used in these image forming methods may be roughly classified into dyes and pigments. A dye is a solvent-soluble coloring agent upon which the properties of individual color-forming molecules are reflected. On the other hand, a pigment is insoluble in a solvent because the molecules of thereof are strongly interacted with each other and is used as a coloring agent in the form of finely divided state. Thus, in general, the dye has a clear color tone but is inferior in discoloration fastness, whereas the pigment has excellent discoloration fastness because of its high inter-molecular interaction. For this reason, only a pigment is used for a colored image requiring high degree of light fastness and weatherability, while a dye may be used when clearness of the color tone is a matter of the highest priority.

Since a colored image is visually recognized by human when exposed to a sufficient light, a high degree of light fastness is essential thereto. Thus, a pigment is used in, for example, a printing ink. A pigment as a coloring agent is generally used to provide a color on a coating covering a base material and is visually recognized as a sum of absorption, reflection and scattering of light incident thereon. Stated otherwise, transparency is not required. In the case of a color filter for liquid crystal display devices, on the other hand, a colored image is required to have high transparency as well as light fastness. Further, in the case of an ink jet method, finer size pigments are needed for its principle of the image forming process. Thus, there is a demand for a color image forming material which has high transparency while ensuring excellent light fastness inherent to the pigment.

For the production of a coloring agent having the required properties, a method is adopted in which the particle size of the pigment is mechanically minimized. With this method, however, it is necessary to conduct operations such as filtration and centrifuge in order to regulate the particle size. Further, there is a limitation in reduction of the particle size to ultra-fine size.

A method is proposed in EP-0654711-A1 to form a colored image of super-fine pigment particles using a pigment precursor soluble in a solvent. In this method, a resin layer having dispersed therein a soluble pigment precursor and a photochemical acid former capable of generating an acid by the action of electromagnetic wave or heat. This method is based on the following principle. With a strong acid formed by the action of light as a catalyst, the soluble pigment precursor undergoes a deprotecting reaction and is transformed to insoluble pigment molecule. Such molecules aggregate in the resin layer to form pigment fine particles. Also, since the solubility of the resin is chemically changed by the acid produced by the action of light, pigment-colored image having high transparency can be obtained by a development treatment.

In the above method using the pigment precursor, the formation of pigment includes a stage in which the acid molecules diffuse in the resin and react with the pigment precursor and a stage in which the pigment molecules thus produced diffuse and aggregate. A velocity at which large size molecules such as strong acid molecules and pigment molecules diffuse in a solid resin is very low. For example, the diameter of the space in which strong acid molecule produced from a photochemical acid former easily causes a catalytic reaction in a solid resin layer is known to be 4-5 nm at 100-120°C which is below the glass transition temperature of the solid resin (see D. R. McKean, R. D. Allen, P. H. Kasai, U. P. Schaedeli, S. A. MacDonald, SPIE, 1672, 94(1992)). On the other hand, in order for the strong acid molecule to get out of the space and to diffuse in the solid resin, heating for at least several tens minutes is required (see L. Schlegel, T. Ueno, N. Hayashi, T. Iwayanagi, Jpn. J. Appl. Phys., 30, 2619 (1991)). These are essential phenomena observed when relatively large organic molecules diffuse in a solid resin. Namely, while a strong acid serving as a catalyst can be generated within a short time by the action of electromagnetic wave or heat, a long heating time is required for completing the deprotecting reaction, because the diffusion rate of the strong acid molecules in the solid resin layer is slow. In this case, however, it is necessary that the reaction resulting in the removal of the protecting group should be quantitatively completed and that the pigment molecules are aggregated to form fine particles in order for the regenerated pigment molecules thus produced to exhibit its inherent color tone. Thus, since large sized pigment molecules must diffuse in the resin layer and aggregate, heating for a long time is required. Further, since the color tone of most of pigments is determined by their intermolecular hydrogen bonding, reproducible color tone cannot be obtained unless the hydrogen bonding pattern is uniform. Thus, there is a great demand for a method which can form a pigment in a more efficient manner.

It is without saying that to increase the rate of the deprotecting reaction of the pigment precursor by the strong acid catalyst is effective in efficiently forming the pigment in the solid resin layer. The deprotecting reaction of the pigment precursor is a bimolecular reaction between the pigment precursor molecule and the strong acid molecule. The rate of the reaction is determined by the rate of diffusion of the strong acid molecules in the solid resin. Therefore, one method to increase the reaction rate will be to elevate the temperature of the solid resin to increase the diffusion rate. Currently, however, there is a limitation to an increase the temperature because of the problem in thermal stability of the solid resin and in production process. A thought may occur to adopt a method in which a large amount of the acid former is used to increase the deprotecting reaction rate. Since, however, light absorption occurs in an upper region of the resin layer, addition of a large amount of a photochemical acid former will adversely affect the efficiency of acid formation inside the resin layer and will cause nonuniformity of the pigment formation in the thickness direction. Thus, the amount of the acid former cannot be increased beyond a certain limit.

The present invention has an objective to provide a coloring composition added to a solid such as solid resins.

### DISCLOSURE OF THE INVENTION

The present inventors have made various studies with a view toward solving the above problems and have conceived an idea of secondarily increasing the number of strong acid molecules which serve to function as a catalyst in a solid resin layer. Namely, the present inventors have conceived that the efficiency of formation of pigment in a solid resin is improved by using an acid proliferation agent which can newly generate a strong acid by the action of a strong acid without resorting to an increase of the amount of an acid former to a non-limited degree.

A photosensitive composition added with an acid proliferation agent is known (JP-A-H08-248561). The acid proliferation agent is a general term of a class of substances that autocatalytically reacts and decomposes by the action of a strong acid to newly generate a strong acid. The acid proliferation agent can generate new strong acid in a number corresponding to the number of the molecules of the acid proliferation agent. Use of the acid proliferation agent for enhancing the sensitivity of a photosensitive resin has been proposed. This proposal is based on the following principle. By the action of activation energy rays such as light, a strong acid is generated from an acid former. With the strong acid thus formed serving as a catalyst, the acid proliferation agent is decomposed to generate new strong acid, sulfonic acid. The strong acid in turn causes chemical modification of the acid-reactive resin or the acid-reactive molecules added to the resin, resulting in a change in solubility. Also proposed is a method of increasing the cationic photopolymerization speed by addition of the acid proliferation agent utilizing the fact that the strong acid serves as a cationic polymerization initiator. On the other hand, it has been thought that since most of pigments have nitrogen atoms which would act as a base and would trap a strong acid, the acid proliferation reaction would not occur. Unexpectedly, however, the acid proliferation agent has been found to exhibit an effect of accelerating the deprotecting reaction. The present invention has been completed based on this finding.

Thus, in accordance with the present invention, there are provided a coloring composition, a transparent colored resin composition, a composition for forming a transparent colored resin and a transparent colored image as follows.
(1) A coloring composition comprising:
   (i) a soluble coloring agent precursor obtained by substituting a hydrogen atom of a NH group of a pigment molecule having at least one NH group with an alkoxycarbonyl group of the following general formula (1): 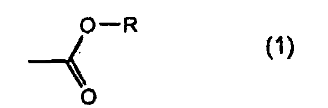
   wherein R represents a tert-butyl group, a tert-amyl group, a 2-phenyl-2-propyl group or a diphenylmethyl group, (ii) an acid proliferation agent newly generating an acid by an action of an acid, and (iii) an acid former generating an acid by the action of activation energy rays or heat.
(2) A transparent, colored resin composition comprising a coloring composition described in (1) above, and a binder resin.
(3) A transparent, colored resin composition as described in (2) above, wherein said binder resin comprises an activation energy rays-sensitive polymer which undergoes a structural change by an action of an acid to cause a change in solubility.
(4) A composition for forming a transparent, colored resin, comprising a coloring composition described in (1) above and dissolved in a cationically polymerizable compound.
(5) A composition for forming a transparent, colored resin, comprising a coloring composition described in (1) above and dissolved in a cationically polymerizable compound and/or radically polymerizable compound.
(6) A transparent colored image formed by irradiating a composition according to any one of (2) through (5) above with activation energy rays.

The essential ingredients of the coloring composition according to the present invention are (i) soluble coloring agent precursor, (ii) an acid proliferation agent and (iii) an acid former. These ingredients will be described below.

As the soluble coloring agent precursor used in the present invention, a compound which has a structure including a pigment skeleton having self-aggregation properties and which has a NH group undergoing deprotecting reaction by an acid catalyzed reaction. The NH group causes self-aggregation by intermolecular hydrogen bonding to form a pigment. Since the acid proliferation reaction is an autocatalytic reaction of the acid proliferation agent, it is not possible to use a coloring agent precursor having a cite which has sufficiently high basicity as compared with the acid proliferation agent molecule. Thus, the acid dissociation constant of the basic cite as the conjugate acid is desired to be about 2 or less. When the acid dissociation constant is greater than 2, the conjugate acid cannot cause acid proliferation reaction. The basic skeleton of pigments that satisfy the above condition may be, for example, quinacridone, anthraquinone, perylene, indigo, quinophthalone, isoindolinone, isoindoline, diketopyrolopyrrole or azo.

The coloring agent precursor used in the present invention may be obtained by alkoxycarbonylation of NH group of the above pigment according to known method (EP-653711-A1). Specific examples of coloring agent precursors are shown below.

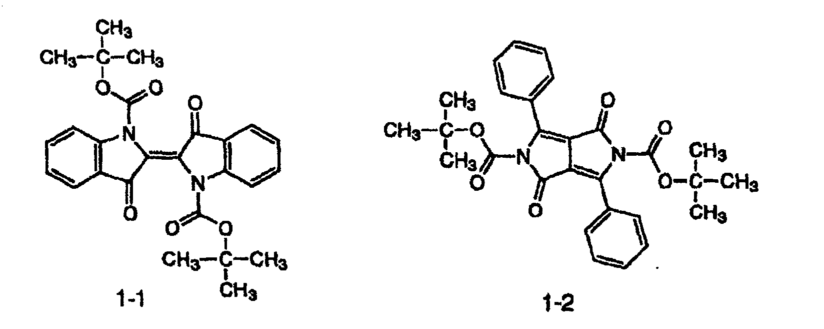

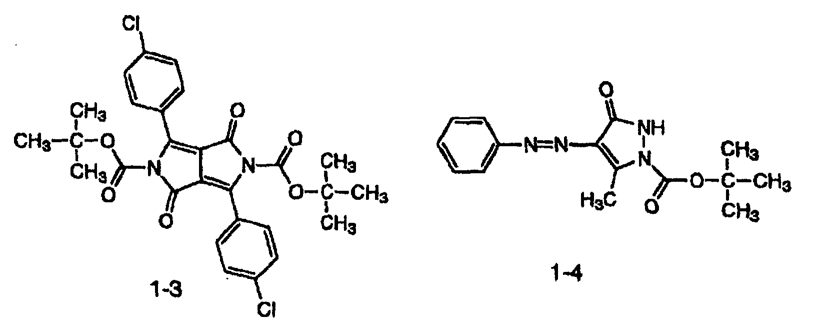

### BRIEF DESCRIPTION OF THE DRAWINGS

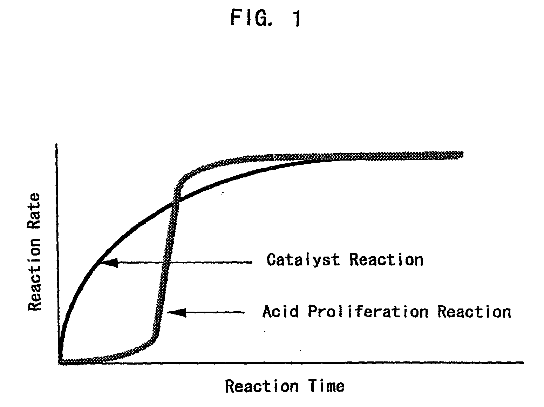

FIG. 1 shows relationship between the reaction rate and the reaction time in the case of an acid catalyzed reaction and in the case of an acid proliferation reaction.

The acid proliferation agent used in the present invention has such properties that it newly generates an acid by the action of an acid and is characterized in that the acid-catalyzed decomposition proceeds such that the change of the rate relative to time draws a sigmoidal curve as shown in FIG. 1 after lapse of a certain induction period. In contrast, the conventional acid catalyzed reaction proceeds to show a simple change represented by an upwardly inflated curve as shown in FIG. 1. Since the acid proliferation agent can decompose by the action of an acid to produce nearly equal amount of acids, the acid concentration can be greatly increased. Several acid proliferation reactions and acid proliferation agents are known (JP-A-H08-248561). The acid proliferation agent suitable for the purpose of the present invention is such that it is stable in the absence of an acid. Specific examples of the acid proliferation agent are shown below. However, the proliferation agent for use in the present invention is not limited to such examples but may be any compound that can cause acid proliferation reaction.

First, there may be mentioned tert-butyl esters of acetoacetic acid derivatives. Typical examples are shown below. These compounds generate sulfonic acids by an acid catalyst through disconnection of tert-butyl-containing groups. Typical examples are shown below.

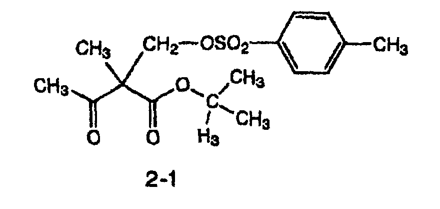

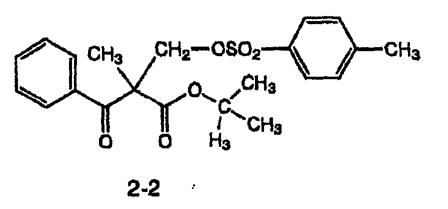

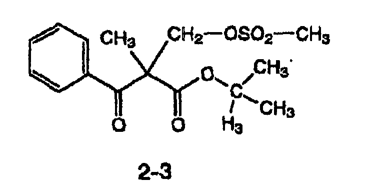

Second, there may be mentioned β-sulfonyloxyketals. Typical examples thereof are shown below. These compounds are converted to β-sulfonyloxyketone and swiftly generate sulfonic acids.

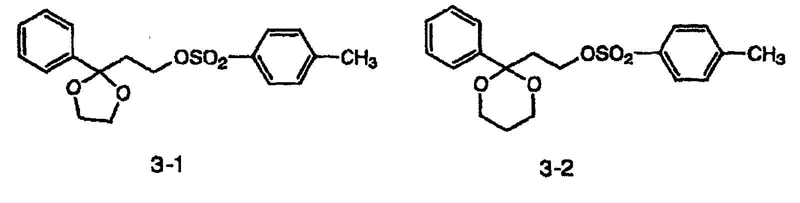

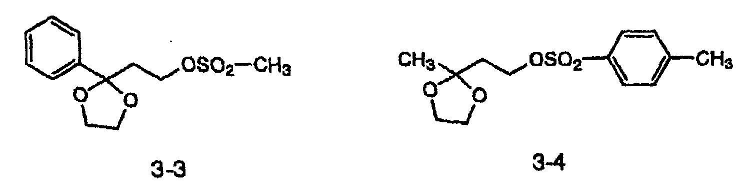

Third, there may be mentioned derivatives of benzylsulfonic acid esters. Specific examples thereof are as follows.

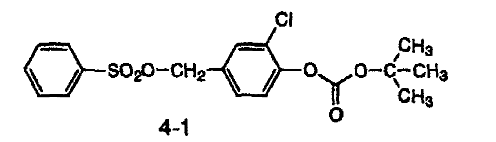

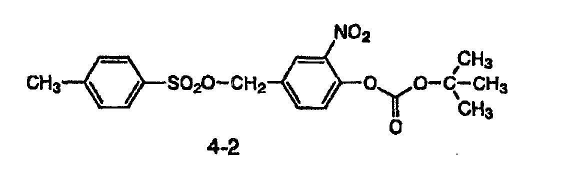

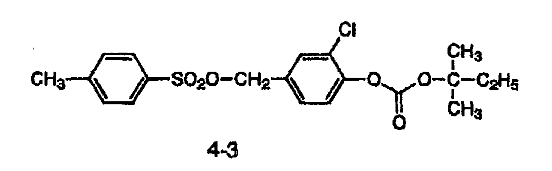

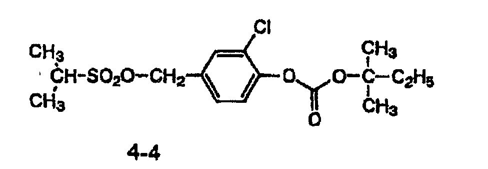

Fourth, there may be mentioned 1,2-cyclohexanediol monosulfonic acid ester derivatives. These compounds cause pinacol rearrangement by an acid catalyst to generate sulfonic acids. Typical examples are shown below.

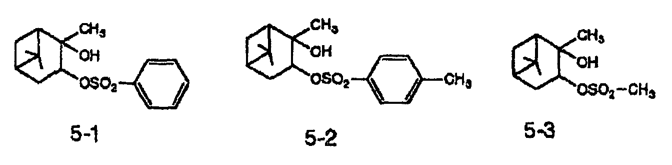

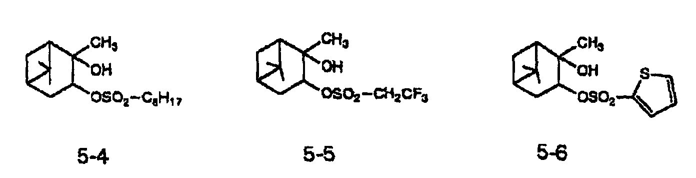

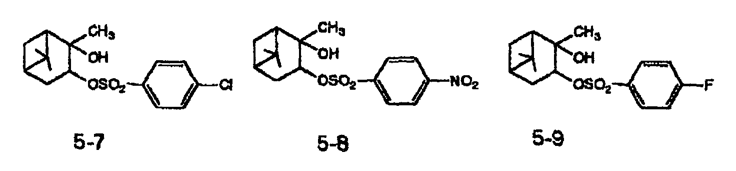

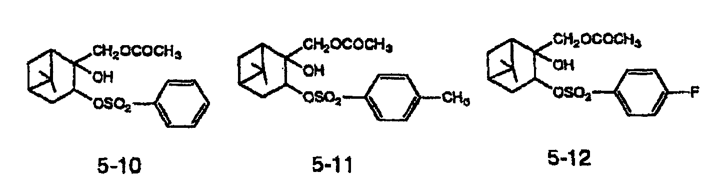

Fifth, there may be mentioned cycloalkanolsulfonic acid ester derivatives. These compounds are decomposed by an acid catalyst into sulfonic acids and cycloalkenes. Typical examples are shown below.

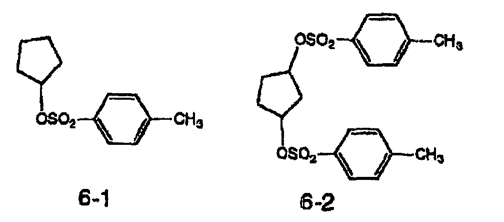

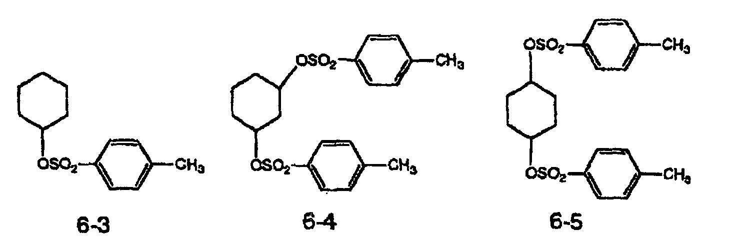

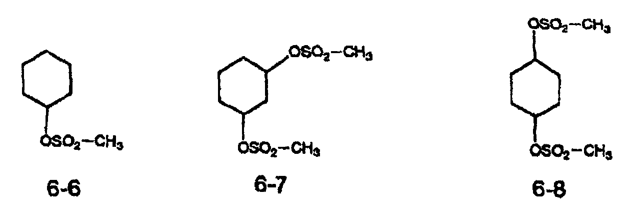

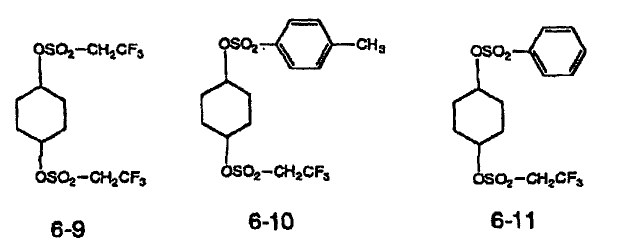

Description will now be made of the acid former required for inducing the acid proliferation reaction and deprotecting reaction of the coloring agent precursor.

As a latent acid former which is capable of releasing an acid upon being subjected to a heat treatment, there may be mentioned known weak base salts of strong acids; onium salts of nitrogen, sulfur and phosphorus atoms; and sulfonic acid salts. The above-mentioned derivatives of benzylsulfonic acid esters and cycloalkanolsulfonic acid ester derivatives, which are autocatalytically decomposed by heat to generate sulfonic acids, may also be suitably used for the purpose of the present invention.

As a photochemical acid former which is capable of releasing an acid by the action of light, there may be mentioned known iodonium salts and sulfonium salts. Specific examples thereof are shown below. The counter anions are, for example, for the Cl⁻, Br⁻, I⁻, BF₄⁻, PF₆⁻, AsF₆⁻, CF₃SO₃⁻, alkanesulfonate having 1-12 carbon atoms, benzensulfonate, substituted benzenesulfonate and naphthalenesulfonate. From the photochemical acid former, a strong acid composed of the counter anion thereof is generated by the action of light.

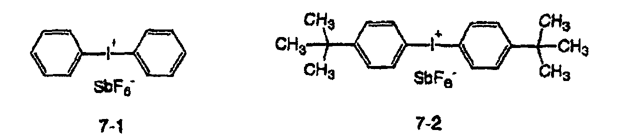

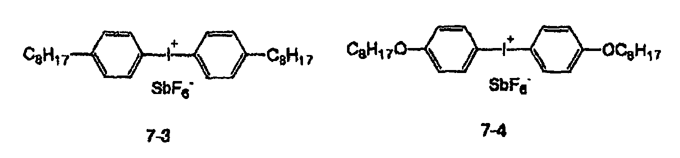

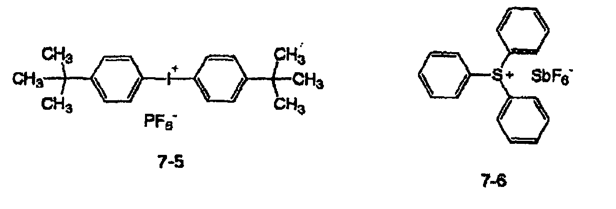

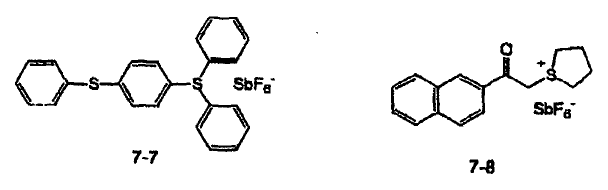

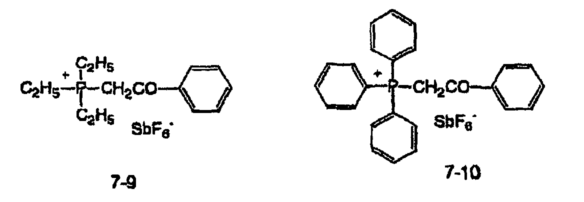

There may be also mentioned sulfonic acid esters or sulfur-containing compounds capable of generating sulfonic acids and polyhalogene compounds capable of generating hydrogen halides. Specific examples thereof are shown below (8-1 through 8-4). The sulfonic acids generated are, for example, methanesulfonic acid, ethanesulfonic acid, propanesulfonic acid, butanesulfonic acid, pentanesulfonic acid, heptanesulfonic acid, octanesulfonic acid, nonanesulfonic acid, decanesulfonic acid, dodecanesulfonic acid, 2-ethylhexanesulfonic acid, cyclohexanesulfonic acid, camphor-10-sulfonic acid, partially fluorinated sulfonic acids thereof, benzenesulfonic acid, p-toluenesulfonic acid, p-fluorobenzenesulfonic acid, p-chlorobenzenesulfonic acid, p-bromobenzenesulfonic acid, p-nitrobenzenesulfonic acid, p-ethylbenzenesulfonic acid, p-propylbenzenesulfonic acid, p-isopropylbenzenesulfonic acid, p-hexylbenzenesulfonic acid, p-decylbenzenesulfonic acid, p-dodecylbenzenesulfonic acid, mesitylenesulfonic acid, 2,4,6-triisopropylbenzenesulfonic acid, 1-naphthalenesulfonic acid and 2-naphthalenesulfonic acid.

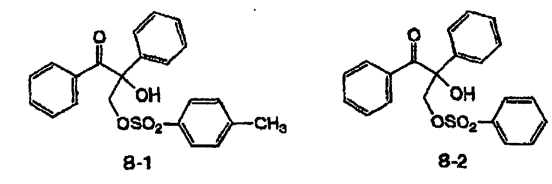

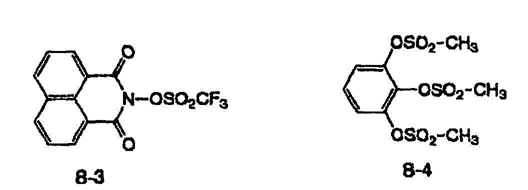

The blending weight ratio of the soluble coloring agent precursor : acid former : acid proliferation agent is 1 : 0.001-0.5 : 0.01-0.5, more preferably 1 : 0.01-0.2 : 0.03-0.3. When the mixing ratio of the acid former relative to the soluble coloring agent precursor is less than the above range, the color change is not sufficiently completed within a short period of time. No additional merit is obtainable when the mixing ratio of the acid former relative to the soluble coloring agent precursor exceeds the above range. Further, since, in the case of an photochemical acid former, the light absorption occurs in an upper region of the resin layer, an amount of the acid former above the above range fails to generate acid uniformly in the depth direction. When the blending amount of the acid proliferation agent relative to the soluble coloring agent precursor is less than the above specified range, the effect of accelerating the color change is not obtainable. Addition of the acid proliferation agent in an amount in excess of the above range fails to give any additional effect.

A binder resin which has self-supporting properties, which is soluble in a solvent and which is compatible with the coloring agent precursor, acid proliferation agent and acid former is suitably used for the above coloring composition. Such resins may be various kinds of thermoplastic resins such as vinyl resins. The vinyl resins may be polymers or copolymers of styrene, m-methylstyrene, p-methylstyrene, p-hydroxystyrene, methyl acrylate, ethyl acrylate, butyl acrylate, 2-ethylhexyl acrylate, benzyl acrylate, phenyl acrylate, 2-tetrahydrofurfuryl acrylate, methyl methacrylate, ethyl methacrylate, butyl methacrylate, 2-ethylhexyl methacrylate, benzyl methacrylate, phenyl methacrylate, 2-tetrahydrofurfuryl methacrylate, acrylonitrile, methacrylonitrile, acrylamide, N,N-dimethylacrylamide, acryloylmorpholide, methacrylamide, N,N-dimethylacrylamide, methacryloylmorpholide, dimethyl fumarate, vinyl acetate, N-vinylpyrrolidone, methyl vinyl ether, butyl vinyl ether, maleimide or N-methylmaleimide. Organic solvent-soluble cellulose derivatives such as triacetylcellulose and ethyl cellulose may also be used.

Further, as the self-supporting binder resin, there may be used novolak resins derived from phenol compounds such as phenol, p-, m- or o-cresol, xylenol, p-tert-butylphenol, o-, m- or p-nonylphenol and resorcinol. Calixarene derivatives which are cyclic compounds of these phenol compounds may also be used. Further, resins obtained by subjecting at least one of the above phenolic hydroxides to methylation, arylation, glycidylation, vinyloxyethylation, propargylation, acetylation or popionylation may also be used. Mixtures of the above resins at any arbitrary mixing ratio may also be used.

The mixing weight ratio of the above coloring composition to the binder resin is 1:1.0 to 1:50.0, preferably 1:2.0 to 1:10.0. An amount of the binder resin less than the above range causes difficulty in obtaining suitable film-forming properties. Too large an amount of the resin in excess of the above range causes difficulty in obtaining sufficient color density.

The activation energy rays-sensitive polymer (photosensitive polymer, etc.) used in conjunction with above the coloring composition is a polymeric material whose side chains or main chains undergo a change in chemical structure by the action of activation energy rays to cause a change in solubility in a solvent. A crosslinking-type polymeric material which causes crosslinking between polymer chains, a decomposition-type polymeric material which undergoes cleavage of its polymer chain, a polymerization-type polymeric material which has at least one radically or cationically polymerizable group and a polymeric material of a type which causes a change in polarity as a result of a change in its side chains may be used. In particular, a polarity-changing-type (chemical proliferation-type), photosensitive polymer of a type which causes a change in the chemical structure thereof by the action of an acid, as a catalyst, that is produced from the acid former upon exposure to activation energy rays is suitable used for the purpose of the present invention.

The blending weight ratio of the coloring composition to the activation energy rays-sensitive polymer is 1:1.0 to 1:50.0, more preferably 1:2.0 to 1:10.0. An amount of the polymer less than the above range causes difficulty in obtaining suitable film-forming properties. Too large an amount of the polymer in excess of the above range causes difficulty in obtaining sufficient color density.

The cationically polymerizable compound used in conjunction with above the coloring composition is a compound which is cured by cationic polymerization using, as an initiator, the acid generated from the acid former contained in the composition. Since the acid generated from the acid proliferation agent can also accelerate the polymerization, the composition for transparent colored image of the present invention is converted to colored, cured material having high transparency upon being exposed to activation energy rays or heat treatment.

As the above cationically polymerizable compound, there may be used a monomer or an oligomer having at least one ring-open polymerizable alicyclic group such as an epoxy group, an oxetane group, an oxazoline group, a spiroorthoester group, a spirocarbonate group or a bicycloorthoester group. A monomer or an oligomer which is substituted with a cationic vinyl-polymerizable group such as vinyloxy, propenyloxy or isopropynyl may also be used. Further, a methylolated compound capable of polymerizing by dehydrative condensation with an acid catalyst may also be suitably used. Mixtures of two or more compounds selected from the above monomers and oligomers having cation polymerizable groups may be also used. The compounds are liquid and are preferably used for dissolving the above coloring composition to form a liquid composition.

The blending weight ratio of the coloring composition to the cationically polymerizable compound is 1:0.3 to 1:50.0, more preferably 1:1.0 to 1:10.0. An amount of the polymerizable compound less than the above range causes difficulty in obtaining suitable film-forming properties. Too large an amount of the polymerizable compound in excess of the above range causes difficulty in obtaining sufficient color density.

The composition according to the present invention for forming transparent, colored images which includes the above coloring composition and a cationically polymerizable compound and/or a radically polymerizable compound utilizes, as polymerization initiating species, radical species as well as the acid generated by the activation energy rays. As the radically polymerizable compound, a (meth)acrylic monomer or oligomer having at least one ethylenically unsaturated bond. The composition of the above-mentioned type may be prepared using the radically polymerizable compound alone or in combination with the above-described cationically polymerizable compound. If desired, a polymerization initiator capable of generating radicals by exposure to electrostatic wave may be added for the acceleration of the radical polymerization.

The blending weight ratio of the coloring composition to the cationically polymerizable compound and/or radically polymerizable compound is 1:0.3 to 1:50.0, more preferably 1:1.0 to 1:10.0. An amount of the polymerizable compound less than the above range causes difficulty in obtaining suitable film-forming properties. Too large an amount of the polymerizable compound in excess of the above range causes difficulty in obtaining sufficient color density.

Description will next be made of a method of forming a colored resin film formed of the above compositions. A solution of a resin composition containing the coloring composition dissolved in a solvent or, when the resin composition is a liquid composition, the liquid resin composition as such is applied to a substrate to form a coated film. The coated film is exposed to activation energy rays to generate an acid and then heated, or the coated film is subjected to a heat treatment when the heat treatment alone can generate an acid, thereby to permit the deprotecting reaction to occur and to complete the formation of the pigment within the resin layer. In the case of using the activation energy rays, it is possible to irradiate the activation energy rays imagewise. An image formed of the colored resin layer is then formed by using, for example, solvent development. This is followed by a heat treatment to complete the formation of the pigment.

By utilization of acid diffusing phenomenon, it is possible to prepare two-layer type, transparent colored resin having a resin layer containing an acid former and a resin layer containing a coloring agent precursor which are separately formed. Namely, a solution of the acid former and a resin A dissolved in a solvent B is prepared. Separately, a solution of the pigment precursor and a resin C dissolved in a solvent D is prepared. In this case, the acid proliferation agent may be dissolved in the solvent B or the solvent D, but is preferably dissolved in the solvent D. It is important that the resin C is insoluble in the solvent B and the resin A is insoluble in the solvent D. A resin layer is formed using the resin A-containing solution, on which the resin C-containing solution is applied to obtain two-layer resin layer. The order of the application can be reversed, if desired. The resulting two-layer resin layer is exposed to heat or light to generate an acid. This is followed by a heat treatment so that the acid molecules diffuse into the other resin layer through the accompanying acid proliferation reaction, thereby realizing the desired formation of the pigment.

Since, according to the present invention, the acid concentration is improved by the generation of new acid as a result of the decomposition of the acid proliferation agent and since the acid molecules are uniformly distributed, the completion of the deprotecting reaction of the soluble coloring agent precursor is accelerated and the formation of fine particles efficiently proceeds by aggregation of the coloring agent molecules. As a consequence, a colored resin layer having both transparency and light fastness is formed while maintaining the color tone inherent thereto. Further, the resin layer having such characteristics permits the formation of images by activation energy rays such as light, so that colored images having both transparency and light fastness may be obtained. Therefore, the composition of the present invention may be suitably used for the preparation of a resin for forming a colored transparent film or various printing inks. With the composition according to the present invention, the hardening speed is improved by the acid proliferation agent, the production efficiency of the products is improved, so that an energy-saving production process can be realized.

### Examples

The present invention will be next described in more detail by examples.

### Example 1

### Synthesis of Pigment Precursor 1:

To 150 mL of N,N-dimethylformamide were added 10.31 g of indigo and 2.79 g of 4-dimethylaminopyridine, to which 45.31 g of di-tert-butyldicarbonate were added dropwise with stirring while cooling in an ice bath. The mixture was then stirred at room temperature for 20 hours. The red precipitates were collected by filtration to obtain N,N'-di(tert-butoxycarbonyl)indigo (hereinafter referred to as indigo precursor) having a melting point of 193-195°C with a yield of 50 %. The elementary analysis values were found to be consistent with the theoretical values.

### Synthesis of Pigment Precursor 2:

To 75 mL of N,N-dimethylformamide were added 5 g of diketopyrolopyrrole and 1.40 g of 4-dimethylaminopyridine, to which 16.14 g of di-tert-butyldicarbonate were added dropwise with stirring while cooling in an ice bath. The mixture was then stirred at room temperature for 22 hours. The yellow powder precipitates were collected by filtration to obtain N,N'-di(tert-butoxycarbonyl)-bis(p-chlorophenyl)diketopyrolopyrrole (hereinafter referred to as DPP precursor) having a decomposition point of 155°C with a yield of 50 %. The product was purified by silica gel column chromatography. The elementary analysis values of the purified sample were found to be consistent with the theoretical values.

### Example 2

In 2 g of dioxane were dissolved 200 mg of poly(α-methylstyrene) as a binder resin. To this solution, 50 mg of the indigo precursor synthesized in Example 1, 12.5 mg of diphenyl-(p-phenylthiophenyl)sulfonium hexafluoroantimonate as a photochemical acid former and 12.5 mg of pinanediol mono(p-toluenesulfonate) as an acid proliferation agent were added to obtain a uniform solution. This solution was then applied to a quartz substrate by spin coating at a revolution speed of 2000 rpm to form a red thin film. The film was irradiated with a monochromatic light of 313 nm at 500 mJ/cm² from a mercury lamp and thereafter heated at 100°C to obtain a transparent blue film. The heating of the blue film was continued while occasionally measuring the UV-visible absorption spectrum to monitor the increase of the absorption at 672 nm by indigo. It was found that the absorption at 672 nm no longer increased 50 minutes after the start of the heating. Similar red thin film was formed on a calcium fluoride substrate and was subjected to irradiation and heating in the same manner as above, while occasionally measuring the FT-IR absorption spectrum to monitor the absorption band at 1681 cm⁻¹ and 1624 cm⁻¹ attributed to the carbonyl groups of the indigo precursor and indigo, respectively. It was found that the indigo precursor completely disappeared and indigo was quantitatively produced 50 minutes after the start of the heating.

### Comparative Example 1

A solution obtained by removing the pinanediol mono(p-toluenesulfonate) being an acid proliferation agent from the composition of Example 2 was applied to a quartz substrate by spin coating in the same manner as that in Example 2 to obtain a red film. This was exposed to light and heated under the same conditions as those in Example 2, while measuring UV-visible absorption spectrum for monitoring the pigment formation. It was found that the saturated value was not reached 50 minutes and still not reached 100 minutes after the start of heating at 100°C. The formation of indigo was observed even after 400 minutes. When the pigment formation was monitored by FT-IT absorption spectrum in the same manner as that in Example 1, it was found that the indigo precursor was not completely disappeared after 400 minutes.

### Example 3

Preparation of film, light exposure and heating were carried out in the same manner as those in Example 2 except that diphenyl-(p-phenylthiophenyl)triflate was used as the acid former. The transformation of the indigo precursor to the blue indigo was found to be completed by 50 minutes heating.

### Example 4

Preparation of film and light exposure were carried out in the same manner as those in Example 2 except that cyclopentyl p-toluenesulfonate was used as the acid proliferation agent. The film was subjected to a heat treatment at 120°C. The transformation of the indigo precursor to the blue indigo was found to be completed by 40 minutes heating.

### Example 5

The composition prepared in Example 2 was applied to a polyester film by spin coating to form a red thin film. This was irradiated through a quartz photo-mask with UV rays and then heated at 100°C for 50 minutes to obtain a clear blue image with red background. The image resolution was 2 µm.

### Example 6

In 2 g of dioxane were dissolved 200 mg of poly(α-methylstyrene), to which 50 mg of the indigo precursor, 10.0 mg of cyclopentyl p-toluenesulfonate as a heat-sensitive acid former and 12.5 mg of pinanediol mono(p-toluenesulfonate) as an acid proliferation agent were added to obtain a uniform solution. This solution was then applied to a glass substrate by spin coating to form a red thin film. The film was heated at 120°C to obtain a transparent blue film. When the acid proliferation agent was not used, the transformation to indigo was not completed even by 400 minutes heating.

### Example 7

In 2 ml of acetone were dissolved 200 mg of cationically polymerizable poly(glycidyl methacrylate), to which 40 mg of the indigo precursor, 12.5 mg of diphenyl-(p-phenylthiophenyl)sulfonium·hexafluoroantimonate as a photo acid former and 12.5 mg of pinanediol mono(p-toluenesulfonate) as an acid proliferation agent were added to obtain a uniform solution. This solution was then applied to a glass substrate by spin coating to form a red thin film. The film was irradiated through a photo-mask with ultraviolet light from a mercury lamp to obtain a transparent blue pattern. The film was then developed with dioxane to remove red-color unexposed portions to leave a blue image.

### Example 8

In 2 ml of acetone were dissolved 200 mg of cationically polymerizable compound, celoxide 2021, 40 mg of the indigo precursor, 12.5 mg of diphenyl-(p-phenylthiophenyl)-sulfonium·hexafluoroantimonate as a photochemical acid former and 12.5 mg of pinanediol mono(p-toluenesulfonate) as an acid proliferation agent to obtain a uniform solution. This solution was subjected to vacuum distillation to remove the solvent, thereby obtaining a viscous red solution. This was applied to a polyester film by a bar coater and the coating was irradiated with ultraviolet light to obtain a hardened red film. The film was heated at 100°C for 40 minutes to obtain a transparent blue film. The film formation, irradiation with ultraviolet light and heat treatment were performed in the same manner as above except that the acid proliferation agent was not used for the purpose of comparison. It was found that the transformation to indigo was not completed even by 500 minutes heating.

### Example 9

In 2 ml of acetone were dissolved 200 mg of a radically polymerizable compound, diethyleneglycol diacrylate, 40 mg of the indigo precursor, 12.5 mg of diphenyl-(p-phenylthiophenyl)sulfonium·hexafluoroantimonate as a photochemical acid former and 12.5 mg of pinanediol mono(p-toluenesulfonate) as an acid proliferation agent to obtain a solution. This solution was subjected to vacuum distillation to remove the solvent, thereby obtaining a viscous red solution. This was applied to a polyester film by a bar coater and the coating was irradiated with ultraviolet light Hardening occurred quickly. The thus hardened red film was heated at 100°C for 40 minutes to obtain a transparent blue film. The film formation, irradiation with ultraviolet light and heat treatment were performed in the same manner as above except that the acid proliferation agent was not used for the purpose of comparison. It was found that the transformation to indigo was not completed even by 500 minutes heating.

### Example 10

In 2 g of dioxane were dissolved 200 mg of poly(α-methylstyrene), to which 50 mg of the DPP precursor synthesized in Example 1, 12.5 mg of diphenyl-(p-phenylthiophenyl)sulfonium hexafluoroantimonate as a photo acid former and 12.5 mg of pinanediol mono(p-toluenesulfonate) as an acid proliferation agent were added to obtain a uniform solution. This solution was then applied to a glass substrate by spin coating to form a yellow thin film. The film was irradiated with ultraviolet light from a mercury lamp and thereafter heated at 100°C to obtain a transparent red film. The heating of the blue film was continued while measuring the absorption spectrum to monitor the change to red. It was found that the reaction almost completely terminated by 40 minutes heating.

### Comparative Example 2

A yellow thin film was prepared from the composition of Example 10 from which pinanediol mono(p-toiuenesulfonate) as an acid proliferation agent was removed. The film was subjected to light exposure and heating while monitoring the change of color from yellow to red by absorption spectrum. It was found that the reaction was not completed even by 400 minutes heating.

## Claims

1. A coloring composition comprising:
(i) a soluble coloring agent precursor obtained by substituting a hydrogen atom of a NH group of a pigment molecule having at least one NH group with an alkoxycarbonyl group of the following general formula (1): 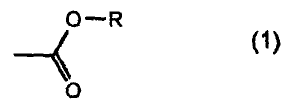 wherein R represents a tert-butyl group, a tert-amyl group, a 2-phenyl-2-propyl group or a diphenylmethyl group,
(ii) an acid proliferation agent newly generating an acid by the action of an acid, and
(iii) an acid former generating an acid by the action of activation energy rays or heat.

2. A transparent, colored resin composition comprising a coloring composition according to claim 1, and a binder resin.

3. A transparent, colored resin composition according to claim 2, wherein said binder resin comprises an activation energy rays-sensitive polymer which undergoes a structural change by the action of an acid to cause a change in solubility.

4. A composition for forming a transparent, colored resin, comprising a coloring composition according to claim 1 dissolved in a cationically polymerizable compound.

5. A composition for forming a transparent, colored resin, comprising a coloring composition according to claim 1 dissolved in a cationically polymerizable compound and/or radically polymerizable compound.

6. A transparent colored image formed by irradiating a composition according to any one of claims 2 through 5 with activation energy rays.
